## Europäisches Patentamt
## European Patent Office
## Office européen des brevets

(19)

(11) Veröffentlichungsnummer: **0 160 056**
**B1**

(12)

# EUROPÄISCHE PATENTSCHRIFT

(45) Veröffentlichungstag der Patentschrift:
**09.03.88**

(21) Anmeldenummer: **84903946.6**

(22) Anmeldetag: **02.11.84**

(86) Internationale Anmeldenummer:
**PCT/CH 84/00176**

(87) Internationale Veröffentlichungsnummer:
**WO 85/01913 (09.05.85 Gazette 85/11)**

(51) Int. Cl.⁴: **B 29 D 9/00,** H 01 H 11/00,
B 32 B 31/04

(54) **VERFAHREN UND VORRICHTUNG ZUM VERPRESSEN VON FLEXIBLEN FOLIEN.**

(30) Priorität: **02.11.83 CH 5926/83**

(43) Veröffentlichungstag der Anmeldung:
**06.11.85 Patentblatt 85/45**

(45) Bekanntmachung des Hinweises auf die Patenterteilung:
**09.03.88 Patentblatt 88/10**

(84) Benannte Vertragsstaaten:
**AT BE CH DE FR GB LI NL SE**

(56) Entgegenhaltungen:
CH - A - 517 622
FR - A - 2 464 195
GB - A - 2 097 588
US - A - 4 317 011

IBM Technical Disclosure Bulletin, vol. 27, no. 4A,
September 1984 New York (US) C.C.Mayborg:"Method
of forming a curved membrane assembly having a
concave top layer", pages 1915, 1916

(73) Patentinhaber: **BÖCK, Josef, Im Steigrüebli,
CH-9400 Rorschacherberg (CH)**

(72) Erfinder: **BÖCK, Josef, Im Steigrüebli,
CH-9400 Rorschacherberg (CH)**

(74) Vertreter: **Justitz-Wormser, Daisy P., Dipl.-Chem. et al,
PATENTANWALTS-BUREAU ISLER AG
Postfach 6940 Walchestrasse 23, CH-8023 Zürich (CH)**

## Beschreibung

Die Erfindung betrifft ein Verfahren zum Verpressen von flexiblen Folien, wobei die Folien fixiert und miteinander verklebt werden.

Ein bekanntes Verfahren zum Verpressen von Folien besteht darin, dass eine Folie von Hand mit einer unter Druck über die Folie geschobenen Gummirakel mit einer zweiten Folie verpresst wird, wobei wenigstens eine Folie mit einer haftenden Schicht versehen ist. Hierbei entsteht ein hoher Ausschuss, da oft Folien gegeneinander verschoben oder zwischen den Folien Luftblasen eingeschlossen sind. Da die Gummirakel an der Presskante nachgiebig ist, werden beispielsweise bei der Herstellung von Tastaturen die Kontaktfolien bei den Kontaktstellen in die Aussparungen der Distanzfolien gedrückt. Damit die herausgepresste Luft zurückströmen und die Distanzfolien sich entspannen können, müssen zwischen den Aussparungen Verbindungskanäle vorhanden sein. Diese Kanäle beeinträchtigen jedoch den Schaltvorgang, da die Luft unter den Tastkuppen beim Niederdrücken durch die Kanäle ausweichen kann und dadurch der Schnapp- oder Knackvorgang akustisch und mit dem Tastgefühl nicht deutlich wahrgenommen wird. Sind bei einer Tastatur Kanäle verstopft, so kann sich die Distanzfolie nicht entspannen, was zu einem Kurzschluss führt.

Durch die US-A-4317011 ist ein Verfahren zur Herstellung von Membrantastaturen bekanntgeworden, bei welchem zum Ausrichten der Folien diese vor dem Verkleben mit einem durch Löcher in den Folien hindurchgesteckten Stift fixiert werden. Das Problem störender Lufteinschlüsse ist bei diesem Verfahren nicht gelöst.

Der Erfindung liegt die Aufgabe zugrunde, ein Verfahren zu schaffen, mit dem Folien lagegenau und schnell und ohne Lufteinschlüsse verpressbar sind. Das Verfahren soll sich zur Durchführung einer weitgehend automatischen Herstellung eignen.

Das erfindungsgemässe Verfahren ist durch die im kennzeichnenden Teil des Anspruchs 1 genannten Merkmale gekennzeichnet.

Weitere vorteilhafte Verfahrensmerkmale ergeben sich aus den abhängigen Verfahrensansprüchen.

Die Erfindung betrifft auch Vorrichtungen zur Durchführung des Verfahrens.

Es ist auch Aufgabe der Erfindung, eine Vorrichtung zu schaffen, die ein genaues und weitgehend automatisierbares Kalt- oder Heissverpressen von Folien gestattet.

Die erfindungsgemässen Vorrichtungen sind gekennzeichnet durch die Merkmale in den kennzeichnenden Teilen der Ansprüche 4 und 8.

Weitere vorteilhafte Ausbildungen ergeben sich aus den abhängigen Vorrichtungsansprüchen.

Das Verfahren, zwei Ausführungsbeispiele der Vorrichtung sowie eine Tastatur werden nachfolgend anhand der Zeichnung näher erläutert. Es zeigen:

Fig. 1 schematisch den Aufbau einer aus vier Folien bestehenden Tastatur,

Fig. 2 einen Querschnitt durch eine Tastatur,

Fig. 3 eine Ansicht einer ersten Variante einer Vorrichtung zum Verpressen von Folien, und

Fig. 4 bis Fig. 8 schematisch die einzelnen Bewegungsschritte beim Verpressen von zwei Folien mittels der Vorrichtung nach der ersten Variante,

Fig. 9 eine teilweise im Schnitt gezeichnete Seitenansicht einer zweiten Variante einer Vorrichtung zum Verpressen von Folien, wobei zur besseren Übersicht einzelne Teile weggelassen sind,

Fig. 10 eine Ansicht der Rückseite der zweiten Variante der Vorrichtung nach Fig. 9, und

Fig. 11a bis 11h schematisch die Bewegungsschritte beim Verpressen von zwei Folien mittels der Vorrichtung nach der zweiten Variante.

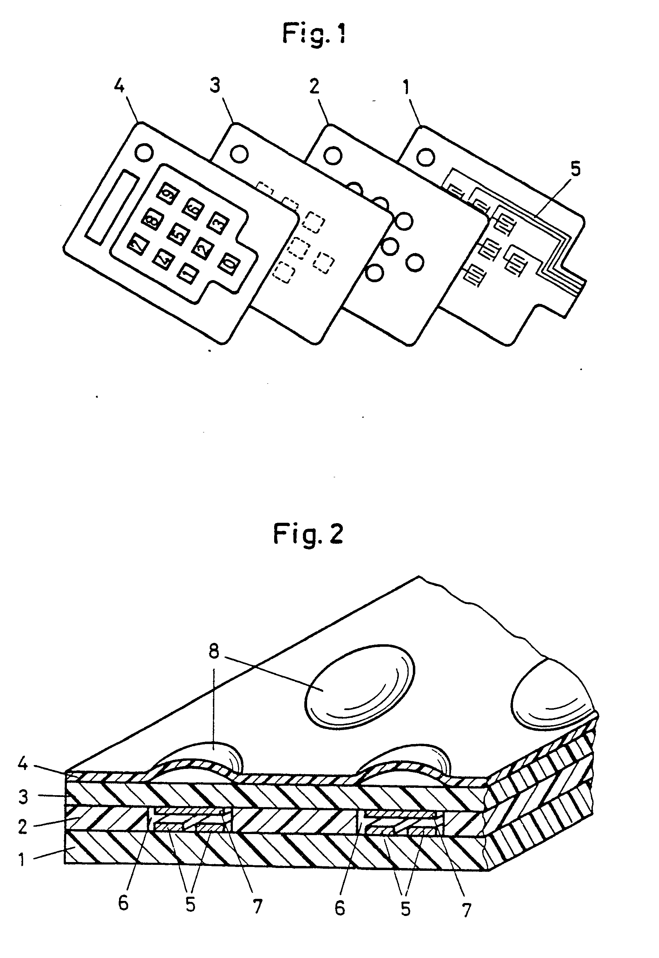

Die Fig. 1 und 2 zeigen beispielhaft eine Tastatur bestehend aus einer Grundfolie 1 mit aufgedruckten Leiterbahnen 5, einer Distanzfolie 2, die an den vorgesehenen Kontaktstellen ausgestanzte Öffnungen 6 besitzt, einer Kontaktfolie 3 mit aufgedruckten Kontaktstellen 7, die beim Tastvorgang den Kontakt mit der Grundfolie 1 herstellen sowie einer Frontfolie mit Tastkuppen 8, die beim Antippen akustisch und durch den Tastsinn den Schaltvorgang anzeigen. Die Folien 1, 2, 3 und 4 bestehen vorzugsweise aus Kunststoff, beispielsweise Polyester, während die Leiterbahnen 5 und die Kontaktstellen 7 aus einem elektrisch leitenden Metall, beispielsweise Silber, bestehen. Je nach Anwendungsgebiet können auch mehr oder weniger Folien oder Schichten vorgesehen sein. Die Frontfolie 4 kann auch eben ohne Tastkuppen ausgebildet sein.

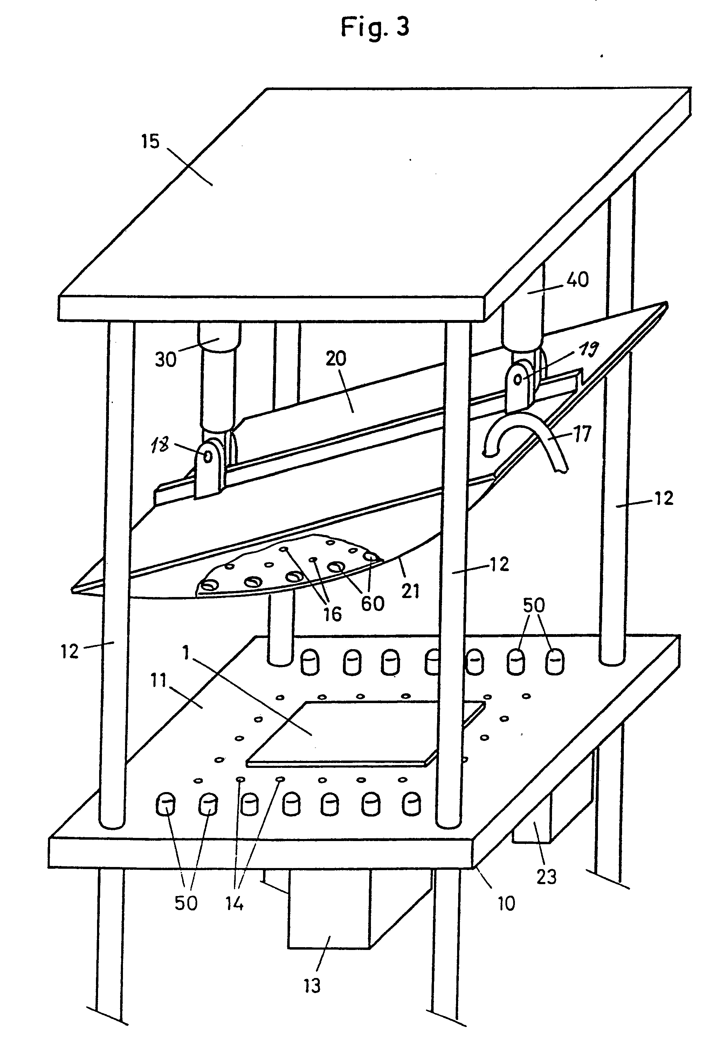

Eine erfindungsgemässe erste Variante einer Vorrichtung zum Verpressen von Folien, beispielsweise zur Herstellung einer Tastatur, ist schematisch in der Fig. 3 dargestellt. Erkennbar ist eine standfest auf Stützen 12 befestigte erste Platte 10 mit einer ebenen Fläche 11, auf der eine grosse Anzahl Öffnungen 14 angeordnet sind, die mit einer Vakuumpumpe 13 verbunden sind. Auf der Fläche 11 kann eine Folie, beispielsweise die Grundfolie 1, in jeder Lage unverrückbar fixiert werden, indem die Folie auf die Fläche gelegt und die Platte 10 evakuiert werden.

Über der Fläche 11 ist an einem standfesten Aufbau 15 eine zweite Platte 20 angeordnet, die eine zur ersten Platte 10 hin gekrümmte Fläche 21 besitzt. Der Krümmungsradius ist beispielsweise 4 m, die Fläche 21 ist also nur wenig gekrümmt.

Die zweite Platte 20 besitzt ebenfalls, hier nicht sichtbar, Öffnungen 16, die über eine flexible Vakuumleitung 17 mit einer hier nicht sichtbaren zweiten Pumpe verbunden sind, so dass auf der gewölbten Fläche 21 eine Folie durch Ansaugen mit guter Planlage fixiert werden kann.

Die zweite Platte 20 ist mit zwei im Abstand zueinander angeordneten Achsengelenken 18 und 19 schwenkbar mit zwei pneumatischen oder hydraulischen Druckzylindern 30 und 40 verbunden. Die Druckzylinder 30 und 40 sind am Aufbau 15 befestigt und stehen senkrecht zur ersten Platte 10. Die Druckzylinder 30 und 40 können auch durch mechanische Bewegungsorgane ersetzt werden. Die zweite Platte 20 kann durch Betätigung der Druckzylinder 30 und 40 in der Höhe verstellt und stufenlos geschwenkt werden. Die zweite Platte 20 kann auf der ersten Platte 10 bzw. auf einer Folie mit konstantem oder veränderlichem Druck abgerollt werden, indem beispielsweise der Druckzylinder 30 soweit verlängert wird, bis der Randbereich 22 der zweiten Fläche 21 mit dem geeigneten Druck auf der Folie aufliegt und indem anschliessend der zweite Zylinder 40 bei gleichzeitiger Verkürzung des Zylinders 30 verlängert wird. Eine Steuervorrichtung 23 steuert die Druckzylinder 30 und 40 sowie die beiden Vakuumpumpen.

Die Abrollbewegung der zweiten Platte 20 wird mit Bolzen 50 geführt, die versenkbar in der ersten Platte 10 befestigt sind und die während der Abrollbewegung in entsprechende Führungsöffnungen 60 in der zweiten Platte 20 eingreifen. Die Führung der Platte 20 ermöglicht eine exakte Positionierung und die genaue Wiederholbarkeit des Abrollvorganges. Es können jedoch auch andere Führungsmittel, beispielsweise ineinandergreifende Zahnschienen oder Verankerungsbänder, vorgesehen sein.

Die erfindungsgemässe Vorrichtung kann mit Heizmitteln versehen und für die Heissverpressung eingesetzt werden.

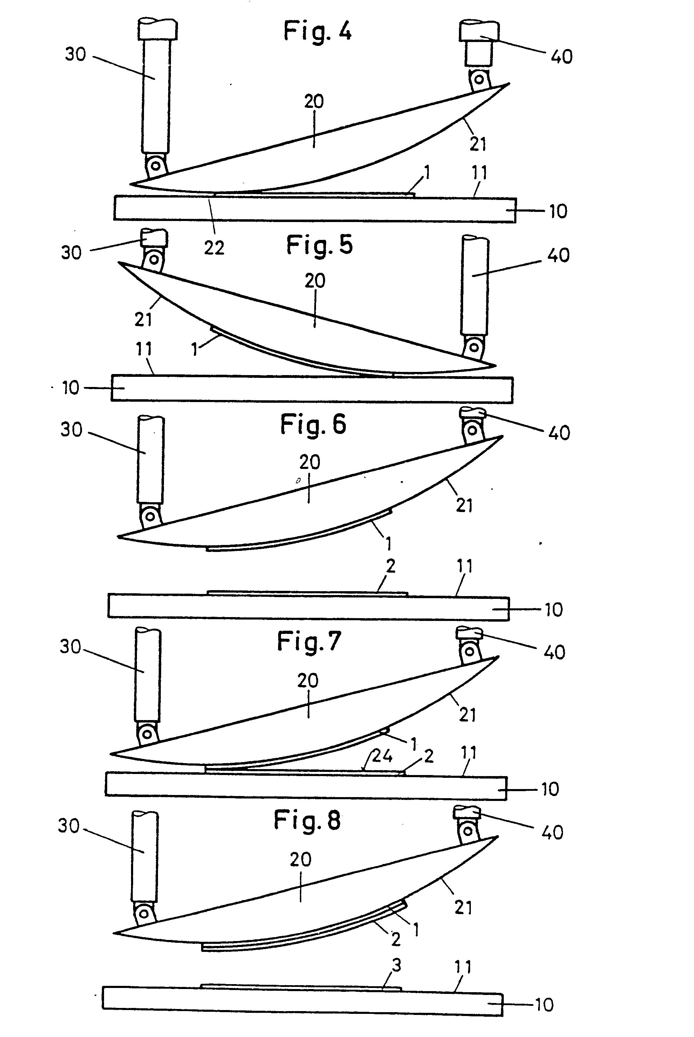

Das Verfahren zur Herstellung einer Tastatur wird im folgenden anhand der Fig. 4 bis 8 näher erläutert. Zuerst wird die Basisfolie 1, die mit hier nicht dargestellten Schutzfolien verklebt sein kann, mit den Leiterbahnen 5 nach unten auf der ersten Fläche 11 genau positioniert und durch Ansaugen plangenau und unverrückbar fixiert. Nun wird die zweite Platte 20 gesenkt, bis der Randbereich 22 mit dem geeigneten Druck auf einem Randbereich der Basisfolie 1 aufliegt (Fig. 4). Die zweite Platte 20 wird nun auf der Basisfolie 1 unter konstantem Auflagedruck abgerollt, wobei die Andruckkraft der ersten Platte 10 gesenkt und diejenige der zweiten Platte 20 erhöht wird, so dass nach einer Abrollbewegung die Basisfolie 1 auf der zweiten Platte 20 plangenau und unverrückbar fixiert ist (Fig. 5).

Die zweite Platte 20 wird gehoben und die Distanzfolie 2 auf der ersten Fläche 11 in der gleichen Lage wie vorher die Grundfolie 1 positioniert und fixiert (Fig. 6). Eventuelle Schutzfolien auf der Grundfolie 1 und der Distanzfolie 2 werden abgezogen und eine Klebemittelschicht 24 auf der Distanzfolie 2 freigelegt (Fig. 7). Nun wird der vorher erwähnte Abrollvorgang exakt wiederholt, wobei die Grundfolie 1 mit der Distanzfolie 2 verklebt wird. Nun wird die Kontaktfolie 3 mit der Distanzfolie 2 verklebt, wobei die bereits erwähnten Bewegungsabläufe wiederholt werden. Dank der guten Planlage der Distanzfolie 2 und der Kontaktfolie 3 wird beim Verkleben aus den Öffnungen 6 keine Luft herausgepresst. Ausgleichskanäle zwischen den Öffnungen 6 sind deshalb nicht erforderlich. Auf die der Frontfolie 4 zugewandten Seite der Kontaktfolie 3 kann eine hier nicht dargestellte dünne Deckfolie aufgeklebt werden, welche den Öffnungen 6 entsprechende Öffnungen aufweist. Wird die Kontaktfolie 3 auf der ersten Platte 10 angesaugt, so wölbt sich die Kontaktfolie 3 bei den Öffnungen der Deckfolie zur ersten Platte 10 hin, so dass der Abstand nach dem Verkleben zwischen der Grundfolie 1 und der Kontaktfolie 3 im Bereich der Öffnungen 6 grösser ist als in den anderen Bereichen. Dadurch wird die Gefahr von Kurzschlüssen weiter vermindert. Abschliessend wird noch die Frontfolie 4 auf die Kontaktfolie 3 aufgeklebt.

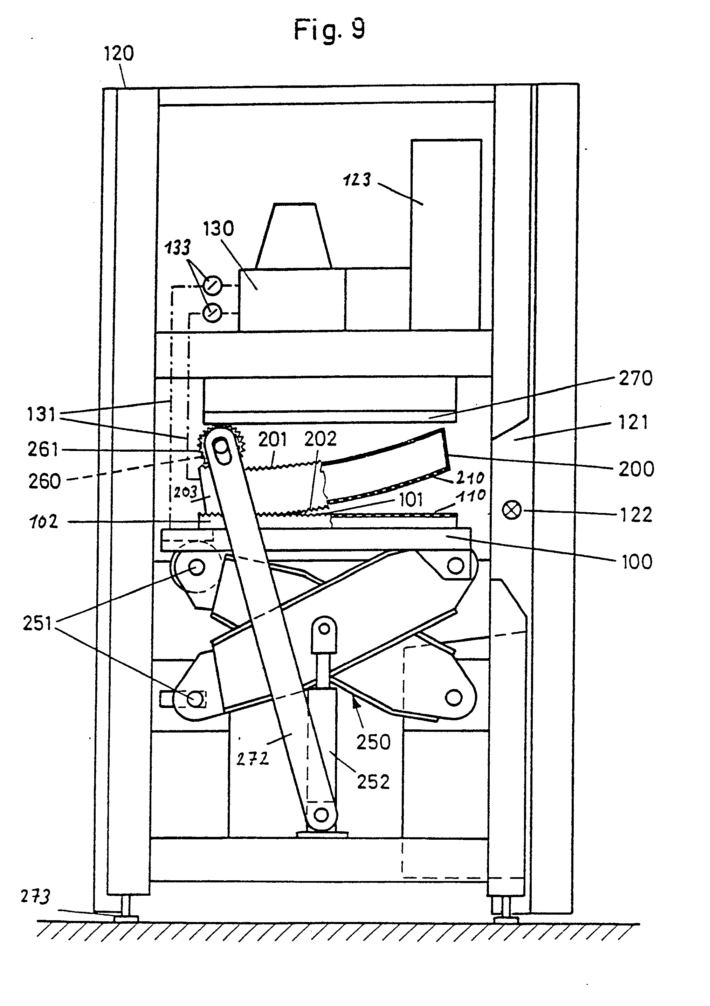

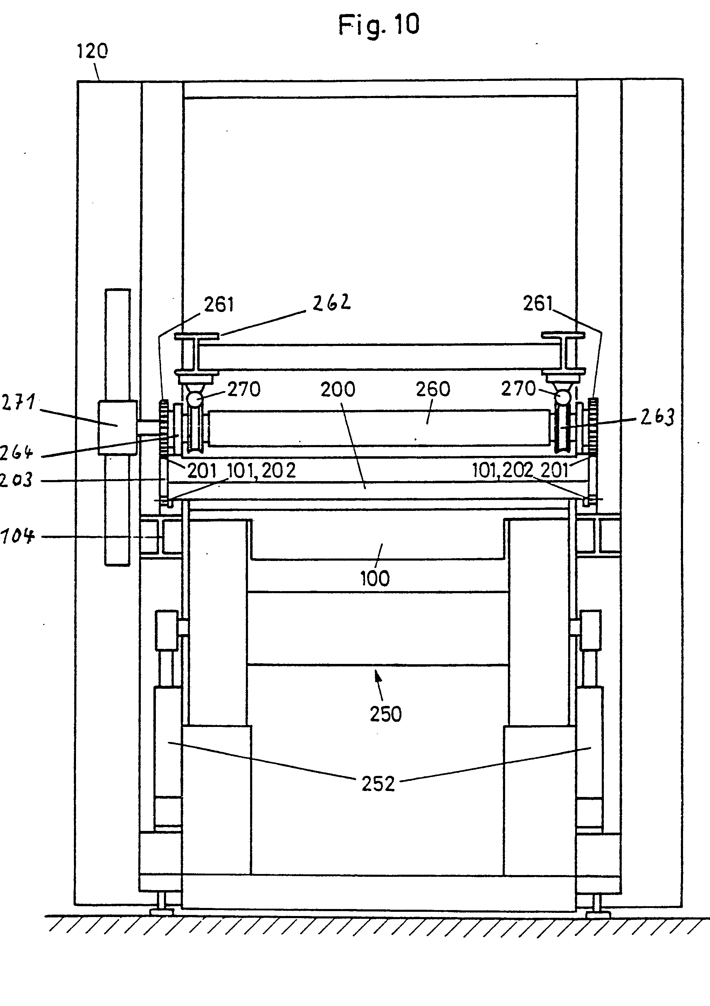

Die in den Figuren 9 und 10 dargestellte zweite Variante einer Vorrichtung zum Verpressen von Folien weist ein verwindungssteifes Maschinengestell 120 auf, das auf vier einstellbaren Tellerfüssen 273 steht. Ein an sich bekannter Scherenhubtisch 250 trägt eine Vakuumplatte 100.

Die Vakuumplatte 100 ist entlang einer ebenen Fläche 110 perforiert. Der Scherenhubtisch 250 wird hydraulisch betätigt, und die Vakuumplatte 100 ist stufenlos höhenverstellbar.

Eine leicht gekrümmte Vakuumplatte 200 liegt abrollbar auf geraden Laufschienen 102, die auf Trägern 104 ruhen. Die Laufschienen 102 sind mit Zahnungen 101 versehen, die mit entsprechenden Zahnungen von Platten 203 kämmen, die seitlich an der gekrümmten Vakuumplatte 200 starr befestigt sind.

Eine Walze 260 mit zwei seitlichen, starr angebrachten Zahnrädern 261 liegt abrollbar auf der gekrümmten Vakuumplatte 200 auf, wobei die Zahnräder 261 mit oberen Zahnungen 201 der Seitenplatten 203 kämmen. Die Walze 260 weist zwei Rollen 263 auf, die auf zwei an Trägern 262 befestigten geraden Stangen 270 abrollen. Die Walze 260 weist zudem zwei Flansche 264 auf, die auf der oberen Fläche der gekrümmten Platte 200 abrollbar aufliegen.

Die Walze 260 ist mittels eines an sich bekannten hydraulischen Drehantriebs 271 um ihre Achse drehbar. Der Drehantrieb 271 läuft mit der Walze 260 mit und ist in hier nicht näher dargestellter Weise an einem schwenkbaren Hebel 272 befestigt. Die Walze 260 kann auch durch einen Elektromotor oder einen anderen geeigneten Antrieb gedreht werden.

Wird die Walze 260 mit dem Antrieb 271 gedreht, rollt diese je nach Drehrichtung entweder vor- oder rückwärts über die gekrümmte Platte 200. Die Platte 200 führt dadurch zwangsweise eine über den ganzen Arbeitsbereich formschlüssige Abrollbewegung aus.

Zwei Vakuumpumpen 130 mit motorisch verstellbaren Steuerventilen 133 sind mittels flexibler Unterdruckschläuche 131 mit der unteren und der oberen Vakuumplatte 100 bzw. 200 verbunden. Die beiden Platten 100 bzw. 200 können also unabhängig voneinander evakuiert und belüftet werden. Die Drücke in den Platten 100 bzw. 200 werden durch je fünf hier nicht dargestellte Leuchtdioden angezeigt.

Der Arbeitsbereich ist durch eine Bedienungsöffnung 121 mit seitlichen Lichtschranken 122 zugänglich.

Die Vorrichtung besitzt weiter eine Steuervorrichtung 123 sowie ein hier nicht dargestelltes Hydraulikaggregat.

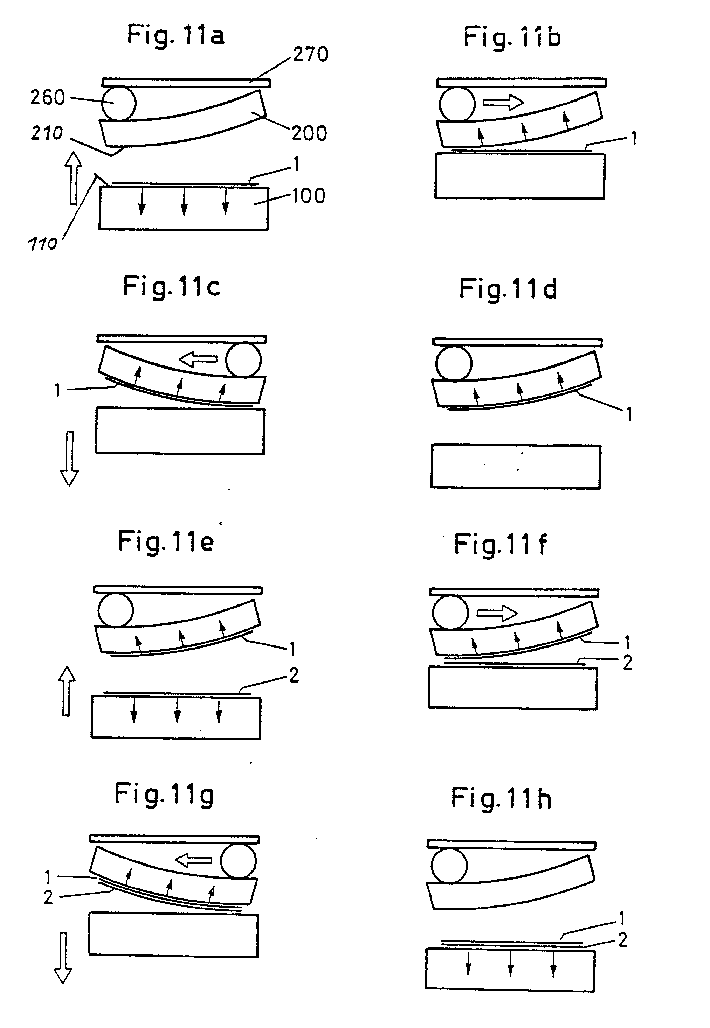

Die Arbeitsweise der Vorrichtung soll anhand der Figuren 11a bis 11h näher erläutert werden.

Durch die Bedienungsperson oder eine automatische Zuführeinrichtung wird durch die Bedienungsöffnung 121 eine Folie 1 eingelegt und wie in Fig. 11a gezeigt auf der unteren Vakuumplatte 100 positioniert und dort angesaugt. Nun wird die untere Vakuumplatte 100 mit dem Scherenhubtisch 250 angehoben, bis die Folie 1 wie in Fig. 11b gezeigt, die obere Vakuumplatte 200 berührt. Die obere Platte 200 wird nun evakuiert und auf der unteren Platte 100 bzw. der Folie 1 abgerollt, wobei gleichzeitig der Druck in der Platte 100 erhöht wird. Sobald die Folie 1 vollständig an der oberen Platte 200 anliegt, wird die untere Platte 100 gesenkt und die obere Platte 200 in die Ausgangsstellung bewegt, so dass der in Fig. 11d gezeigte Zustand erreicht ist. Nun wird eine zweite Folie 2 eingelegt und auf der unteren Platte 100 fixiert sowie anschliessend die untere Platte 100 angehoben. Die obere Platte 200 wird mit dem geeigneten Druck auf der unteren Folie 2 abgerollt und gleichzeitig der Druck in der unteren Platte erhöht.

Die Folie 2 ist nun vollständig mit der Folie 1 verpresst (Fig. 11g). Die obere Platte 200 wird nun in die Ausgangslage bewegt, wobei gleichzeitig die untere Platte 100 evakuiert und der Druck in der oberen Platte 200 erhöht wird. Der Druck in der unteren Platte 100 wird nun erhöht und die beiden verpressten Folien abgehoben, so dass ein neuer Arbeitszyklus beginnen kann. Es versteht sich von selbst, dass nach diesem Verfahren auch mehr als zwei Folien verpresst werden können.

**Patentansprüche**

1. Verfahren zum Verpressen von flexiblen Folien, wobei die Folien fixiert und miteinander verklebt werden, dadurch gekennzeichnet, dass eine Seite einer ersten Folie (1) auf einer ersten Fläche (21; 210) lösbar befestigt wird und dass eine Seite einer zweiten Folie (2) auf einer zweiten Fläche (11; 110) lösbar befestigt wird und die beiden Folien (1, 2) mit einer Abrollbewegung der einen Fläche (11; 110 bzw. 21; 210) miteinander verklebt werden, wobei wenigstens eine der beiden Flächen (11; 110 bzw. 21; 210) gekrümmt ist.

2. Verfahren nach Anspruch 1 oder 2, dadurch gekennzeichnet, dass die Folien (1, 2, 3, 4) durch Ansaugen auf den Flächen (11, 21; 110, 210) befestigt werden und beim Lösen der Folien (1, 2, 3, 4) der Ansaugdruck vermindert wird.

3. Verfahren nach Anspruch 1 oder 2, dadurch gekennzeichnet, dass zur Herstellung von Tastaturen zuerst eine Grundfolie (1) mit einer Distanzfolie (2), dann diese beiden Folien (1, 2) mit einer Kontaktfolie (3) und diese drei Folien (1, 2, 3) mit einer Frontfolie (4) verklebt werden.

4. Vorrichtung zur Durchführung der Verfahren nach den Ansprüchen 1 bis 3 mit Mitteln zum Fixieren der Folien, dadurch gekennzeichnet, dass an einem Gestell (12) eine erste Platte (10) mit einer ersten ebenen Fläche (11) und eine zweite bewegliche Platte (20) mit einer zweiten, gekrümmten Fläche (21) befestigt sind, dass die zweite Platte (20) mittels Bewegungsorganen (30, 40) auf der ersten Fläche (11) unter Druck abrollbar und höhenverstellbar ist, dass Führungsmittel (50, 60) zur Führung der zweiten Platte (20) während der Abrollbewegung vorgesehen sind und dass beide Platten (10, 20) Mittel (14, 16) zum lösbaren Befestigen flexibler Folien (1, 2) aufweisen.

5. Vorrichtung nach Anspruch 4, dadurch gekennzeichnet, dass die beiden Platten (10, 20) Vakuumplatten zum Ansaugen der Folien (1, 2) auf den Platten (10, 20) sind.

6. Vorrichtung nach Anspruch 4, dadurch gekennzeichnet, dass die Bewegungsorgane (30, 40) pneumatische oder hydraulische Druckzylinder sind.

7. Vorrichtung nach Anspruch 4, dadurch gekennzeichnet, dass als Führungsmittel (50, 60) senkbare Bolzen (50) vorgesehen sind, die auf der ersten Platte (10) befestigt sind und die bei einer Abrollbewegung der zweiten Platte (20) in Führungsöffnungen (60) der zweiten Platte (20) eingreifen.

8. Vorrichtung zur Durchführung der Verfahren nach den Ansprüchen 1, 2 oder 3 mit Mitteln zum Fixieren der Folien, dadurch gekennzeichnet, dass an einem Gestell (120) eine erste Platte (100) mit einer ebenen Fläche (110) und eine zweite Platte (200) mit einer gekrümmten Fläche (210) befestigt sind, dass die erste Platte (100) mittels einer Hubvorrichtung (250) höhenverstellbar ist und die zweite Platte (200) mittels Bewegungsorganen (260, 271) auf der ebenen Fläche (110) unter Druck abrollbar ist, dass Führungsmittel (270, 201, 202, 101) zur formschlüssigen Führung der zweiten Platte (200) vorgesehen sind und dass beide Platten (100, 200) Mittel zum lösbaren Befestigen von Folien (1, 2) aufweisen.

**Claims**

1. Process for compressing flexible sheets, the sheets being fixed and bonded to one another, characterized in that one side of a first sheet (1) is detachably fastened on a first surface (21; 210) and in that one side of a second sheet (2) is detachably fastened on a second surface (11; 110) and the two sheets (1, 2) are bonded to each other by a rolling motion of the one surface (11; 110 or 21; 210), at least one of the two surfaces (11; 110 or 21; 210) being curved.

2. Process according to claim 1 or 2, characterized in that the sheets (1, 2, 3, 4) are fastened on the surfaces (11, 21; 110, 210) by suction and the suction pressure is reduced when detaching the sheets (1, 2, 3, 4).

3. Process according to claim 1 or 2, characterized in that, for the fabrication of keyboards, firstly a base sheet (1) is bonded to a spacing sheet (2), then these two sheets (1, 2) are bonded to a contact sheet (3) and these three sheets (1, 2, 3) are bonded to a front sheet (4).

4. Apparatus for implementation of the processes according to claims 1 to 3, with means for the fixing of the sheets, characterized in that a first plate (10), having a first flat surface (11), and a second movable plate (20), having a second, curved surface (21), are secured to a frame (12), in that the second plate (20) can be rolled under pressure on the first surface (11) and adjusted in height by means of moving elements (30, 40), in that guiding means (50, 60) for guidance of the second plate (20) during the rolling motion are provided and in that both plates (10, 20) have means (14, 16) for the detachable fastening of flexible sheets (1, 2).

5. Apparatus according to claim 4, characterized in that the two plates (10, 20) are vacuum plates for sucking the sheets (1, 2) onto the plates (10, 20).

6. Apparatus according to claim 4, characterized in that the moving elements (30, 40) are pneumatic or hydraulic compression cylinders.

7. Apparatus according to claim 4, characterized in that retractable bolts (50) are provided as guiding means (50, 60), which bolts are secured on the first plate (10) and engage in guide openings (60) of the second plate (20) during a rolling motion of the second plate (20).

8. Apparatus for implementation of the processes according to claim 1, 2 or 3, with means for the fixing of the sheets, characterized in that a first plate (100), having a flat surface (110), and a second plate (200), having a curved surface (210), are secured to a frame (120), in that the first plate (100) can be adjusted in height by means of a lifting mechanism (250) and the second plate (200) can be rolled under pressure on the flat surface (110) by means of moving elements (260, 271), in that guiding means (270, 201, 202, 101) are provided for the positive guidance of the second plate (200) and in that both plates (100, 200) have means for the detachable fastening of sheets (1, 2).

**Revendications**

1. Procédé pour comprimer des feuilles flexibles, ces feuilles étant fixées et collées les unes aux autres, caractérisé par le fait qu'une face d'une première feuille (1) est fixée amoviblement sur une première surface (21; 210); et par le fait qu'une face d'une seconde feuille (2) est fixée amoviblement sur une seconde surface (11; 110) et les deux feuilles (1, 2) sont collées l'une à l'autre par un roulement basculant de l'une (11; 110 ou 21; 210) des surfaces, au moins l'une des deux surfaces (11; 110 ou 21; 210) étant curviligne.

2. Procédé selon la revendication 1 ou 2, caractérisé par le fait que les feuilles (1, 2, 3, 4) sont fixées sur les surfaces (11, 21; 110, 210) par aspiration, la pression d'aspiration étant réduite lors du dégagement des feuilles (1, 2, 3, 4).

3. Procédé selon la revendication 1 ou 2, caractérisé par le fait que, pour fabriquer des claviers, une feuille de base (1) est tout d'abord collée à une feuille d'espacement (2), puis ces deux feuilles (1, 2) sont collées à une feuille de contact (3), et ces trois feuilles (1, 2, 3) sont collées à une feuille frontale (4).

4. Dispositif pour la mise en œuvre du procédé selon les revendications 1 à 3, comportant des moyens pour fixer les feuilles, caractérisé par le fait qu'une première plaque (10) munie d'une première surface plane (11) et une seconde plaque mobile (20), munie d'une seconde surface curviligne (21), sont fixées à un bâti (12); par le fait que la seconde plaque (20) peut accomplir un roulement basculant sous pression et est réglable en hauteur sur la première surface (11), au moyen d'organes moteurs (30, 40); par le fait que des moyens de guidage (50, 60) sont prévus pour guider la seconde plaque (20) lors du roulement basculant; et par le fait que les deux plaques (10, 20) présentent des moyens (14, 16) assurant la fixation libérale de feuilles flexibles (1, 2).

5. Dispositif selon la revendication 4, caractérisé par le fait que les deux plaques (10, 20) sont des plaques de dépression, pour aspirer les feuilles (1, 2) sur ces plaques (10, 20).

6. Dispositif selon la revendication 4, caractérisé par le fait que les organes moteurs (30, 40) sont des vérins pneumatiques ou hydrauliques.

7. Dispositif selon la revendication 4, caractérisé par le fait qu'on a prévu, en tant que moyens de guidage (50, 60), des tenons enfonçables (50) qui sont fixés sur la première plaque (10) et qui, lors d'un roulement basculant de la seconde plaque (20), pénètrent dans des orifices de guidage (60) de cette seconde plaque (20).

8. Dispositif pour la mise en œuvre du procédé selon les revendications 1, 2 ou 3, présentant des moyens pour fixer les feuilles, caractérisé par le fait qu'une première plaque (100) munie d'une surface plane (110) et une seconde plaque (200), munie d'une surface curviligne (210), sont fixées à un bâti (120); par le fait que la première plaque (100) est réglable en hauteur au moyen d'un dispositif élévateur (250) et la seconde plaque (200) peut accomplir un roulement basculant sous pression sur la surface plane (110), au moyen d'organes moteurs (260, 271); par le fait que des moyens de guidage (270, 201, 202, 101) sont prévus pour guider la seconde plaque (200) par concordance de formes; et par le fait que les deux plaques (100, 200) présentent des moyens assurant la fixation libérale de feuilles (1, 2).

# Fig. 1

# Fig. 2

# Fig. 3

Fig. 4

Fig. 5

Fig. 6

Fig. 7

Fig. 8

# Fig. 9

# Fig. 10

0160056

Fig. 11a

270
260
210
200
1
100
110

Fig. 11b

1

Fig. 11c

1

Fig. 11d

1

Fig. 11e

1
2

Fig. 11f

1
2

Fig. 11g

1
2

Fig. 11h

1
2

17